Europäisches Patentamt

European Patent Office

Office européen des brevets

⑩

(11) Publication number: **0 205 917**
**B1**

# EUROPEAN PATENT SPECIFICATION

(12)

(45) Date of publication of patent specification: **31.10.90**

(21) Application number: **86106806.2**

(22) Date of filing: **20.05.86**

(51) Int. Cl.⁵: **H 01 J 37/34,** H 01 J 37/20, C 23 C 14/56

(54) **Sputtering apparatus.**

(30) Priority: **21.05.85 JP 109090/85**
**21.05.85 JP 109091/85**
**21.05.85 JP 109092/85**
**21.05.85 JP 109093/85**
**21.05.85 JP 109094/85**

(43) Date of publication of application:
**30.12.86 Bulletin 86/52**

(45) Publication of the grant of the patent:
**31.10.90 Bulletin 90/44**

(84) Designated Contracting States:
**DE FR GB IT**

(56) References cited:
**EP-A-0 040 437**
**CH-A- 320 337**
**DE-C- 760 543**
**JP-A-60 067 671**
**US-A-4 221 652**

(73) Proprietor: **TOYODA GOSEI CO., LTD.**
**1, Aza-Nagahata Ohaza-Ochiai Haruhimura**
**Nishikasugai-gun Aichi-ken (JP)**

(72) Inventor: **Manabe, Katsuhide c/o Toyoda Gosei Co., Ltd.**
**1, Nagahata, Ochiai Haruhi-mura**
**Nishikasugai-gun Aichi-ken (JP)**
Inventor: **Tsutsui, Masatoshi c/o Toyoda Gosei Co., Ltd.**
**1, Nagahata, Ochiai Haruhi-mura**
**Nishikasugai-gun Aichi-ken (JP)**

(74) Representative: **Vetter, Ewald Otto, Dipl.-Ing.(FH) et al**
**Bahnhofstrasse 30**
**D-8900 Augsburg (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a sputtering apparatus according to the preamble of claim 1.

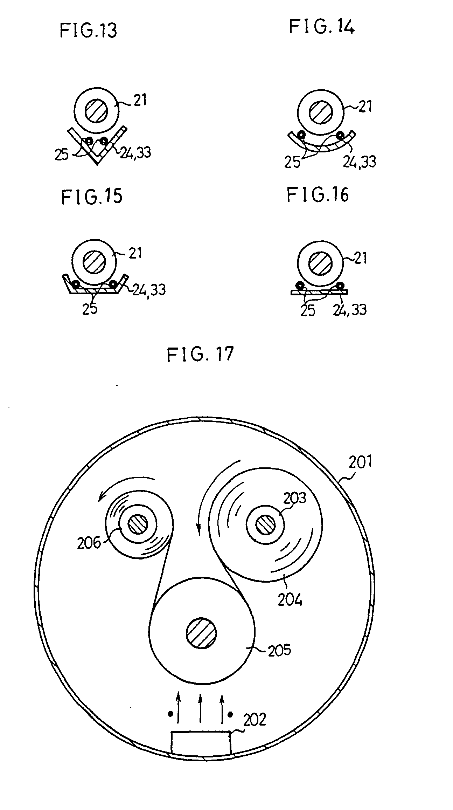

Such a sputtering apparatus of the winding type is shown in Fig. 17. An apparatus of this known type has a tank 201 in which a target 202 in the form of a flat plate is horizontally disposed, and a length of material 204 which is supplied from a supplying roller 203 extends around a guide roller 205 disposed opposite and parallel to the target 202 and is then wound around a winding roller 206. Since, in this arrangement the area on which the sputtering metal which has flown off the target 202 attaches is small, it is difficult to increase the winding speed. Since the arrangement uses a flat plate target, it necessitates a high sputtering pressure of about 0,1333 Pa ($10^{-3}$ Torr), so that the color of a metal coating formed on the length of material 204 tends to be blackish.

In addition, the length of material 204 may become loose on the side of the guide roller 205, owing to its weight and slippage, and it may become wrinkled. In such a case, the metal may not stick to the material surface. Thus is a possibility of unevenness in the metal coated over the length of material.

DE—C—760 543 shows an apparatus for treating a length of material with metal while transferring said length of material via guide rollers being disposed on a circumferential surface concentric with a source of metal thermically evaporating said metal. JP—A—60-67 671 & Patent Abstract of Japan, Vol. 9, No. 200 (C-298) (1923), 16 Aug. 1985, shows an apparatus for treating a material web with plasma gas. In the middle of a frame guiding the material web an electrode is provided for generating plasma gas. However, there are no guide rollers and no metal source.

It is an object of the present invention to provide a sputtering apparatus which has a high sputtering speed and which enables a sputtering metal to be attached over a wide area of a length of material, and to be securely formed to a prescribed thickness on the surface thereof without the metal coating becoming blackish; even if the length of material is wound at a higher speed. Further, the length of material shall be prevented from being contaminated by sputtering metal sticking to the guide roller, or being affected by the heat applied to the guide roller.

It is a still further object of the present invention to provide a sputtering apparatus which prevents the length of material from loosening during the sputtering process and which is capable of producing a length of material to which the sputtering metal is attached uniformly.

These objects are achieved according to the invention by a sputtering apparatus comprising the characterizing features of claim 1.

Other objects of the present invention will be apparent when the same is read in conjunction with the preferred embodiments described below, and various advantages of the present invention will be thereafter apparent to those who skilled in the art.

Fig. 1 is a sectional plan view of the body of a sputtering apparatus which is the first embodiment of the present invention;

Fig. 2 is a partially cut away front view of the sputtering apparatus shown in Fig. 1;

Fig. 3 is a sectional view taken along a line III—III of Fig. 1;

Fig. 4 is a partial perspective view illustrating a portion around a rack of the first embodiment;

Fig. 5. is a sectional plan view of a sputtering apparatus which represents an altered example of the first embodiment.

Fig. 6 is a sectional plan view of the body of a sputtering apparatus which is the second embodiment of the present invention;

Fig. 7 is a partially cut away front view of the sputtering apparatus shown in Fig. 6;

Fig. 8 is a sectional view taken along a line VIII—VIII of Fig. 6;

Figs. 9 and 10 are sectional plan views of sputtering apparatuses representing altered examples of the second embodiment;

Figs. 11 and 12 are perspective views illustrating guide rollers which are other examples of guide rollers incorported in the first and second embodiments;

Figs. 13 to 16 are a sectional plan views of other examples of guard members incorporated in the first and second embodiments;

Fig. 17 is a longitudinal sectional view of a sputtering apparatus according to a related conventional method.

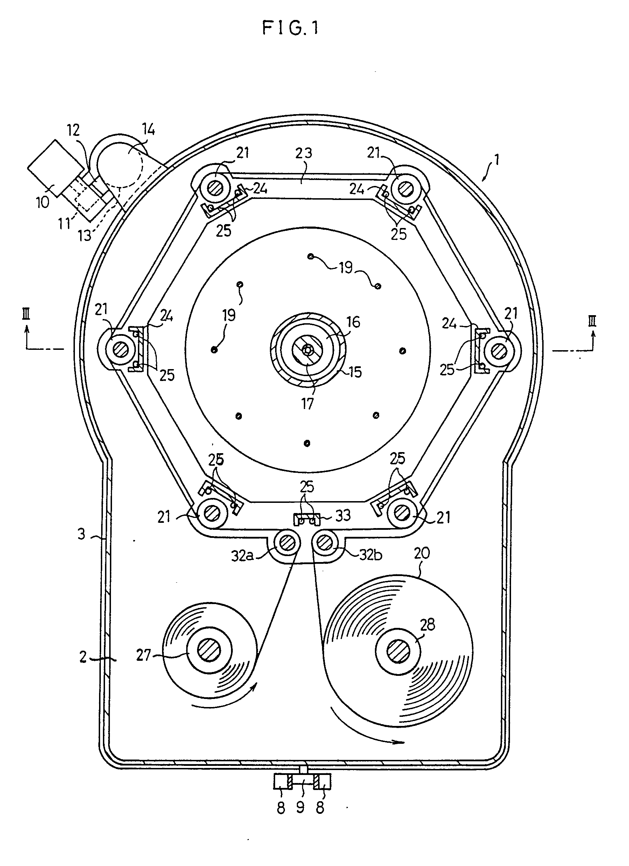

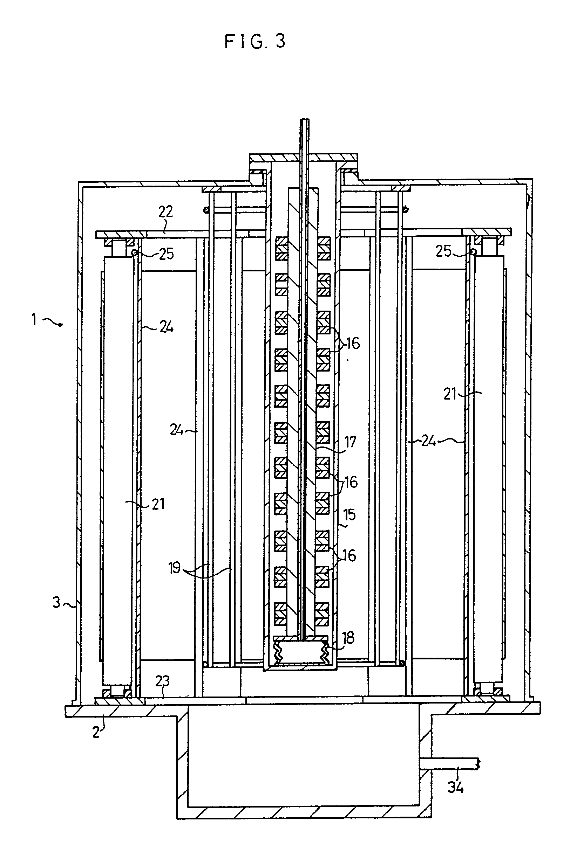

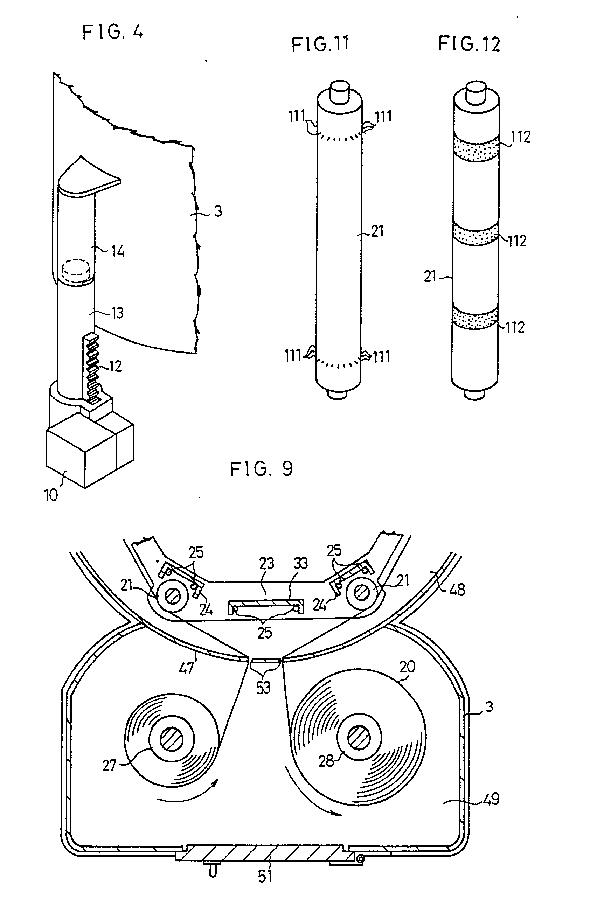

The first embodiment of the present invention will be described hereunder with reference to Figs. 1 to 4. The body 1 of a sputtering apparatus is formed by a base support 2 and a casing 3 mounted on the base support 2 with a packing (not shown) interposed therebetween such as to make this portion air-tight. Two pairs of stationary blocks 4 which are rotatably supported by a frame (not shown) are disposed above the casing 3. Two wires 5 for suspending the casing 3 each of which is connected at its one end to a hooking ring 6 fixed to and protruding from the upper portion of the casing 3 and is connected at the other end to a balancing weight 7 are wound around the stationary blocks 4. The total weight of the two balancing weights 7 is set to be slightly lighter than the weight of the casing 3 so that the casing 3 can be moved up and down by small force. A roller 9 which engages with a guide rails 8 vertically disposed in the vicinity of the casing 3 is rotatably attached to the front of the casing 3 (shown in the lower part of Fig. 1). As shown in Figs. 1 and 4, a rack 12 adapted for engaging with a pinion 11 which is attached to the rotationg shaft of a motor 10 is provided on the rear portion of the casing 3 where an engaging portion 14 adapted for engaging with the top of a pushing-up member 13 which is moved up and down in accordance with the normal and reverse rotation of the motor 10 is protrusively formed. The casing 3 is thereby raised and falled by the vertical movement of the pushing-up member 13.

A target 15 in the form of a cylinder having a bottom is detachably suspended at the center of the cylindrical portion of the casing 3. At least the outermost stratum of the target 15 is formed of sputtering metal, and a supporting cylinder 17 to which permanent magnets in the form of rings 16 are fitted in given spaced apart relationship with each other is inserted into the interior space of the target 15. A bellows 18 into which a quantity of compressed air is supplied from the outside is disposed under the supporting cylinder 17 so as to moving this up and down in accordance with the state of the compressed air being supplied or discharged. An anode 19 in the form of a cage having eight vertically extending thin rods is disposed around a cathode or the target 15 such that the thin rod portions are located on a circumferential surface concentric with the target 15. A direct current voltage of 50 to 1000 is applied between the cathode or the target 15 and the anode 19.

At the circumference of the cylindrical targe 15, six guide rollers 21 for guiding a length of material 20 such as cloth and a film are disposed at equal intervals on a circumference which is concentric with the target 15. The guide rollers 21 are mounted on the base support 2 and are rotatably supported between an upper supporting frame 22 substantially in the form of a hexagon and lower supporting frame 23.

Pillars 24 for supporting the upper supporting frame 22 function as guard member for preventing sputtering metal from sticking to each guide roller 21, and so they are disposed on the inner side of the guide roller 21 and each of them are formed such as to be wider than the diameter of the guide roller 21. A water cooling piping 25 is disposed on one side of each pillar 24 opposite to the surface which faces the target 15.

A supplying roller 27 for supplying a length of material and a winding roller 28 for winding up the length of material 20 which has undergone a sputtering treatment are rotatably disposed vertically on the outside of the outer circumferential surface formed by the guide rollers 21. Both rollers 27 and 28 are respectively disposed on the base support 2 and detachably supported between driving shafts 29a and 29b driven by external driving mechanism (not shown) and driven shafts 31a and 31b rotatably attached to a supporting bracket 30 protrusively mounted on the upper support frame 22. A pair of auxiliary guide rollers 32a and 32b are disposed between one pair of the guide rollers 21 which are adjacent to the rollers 27 and 28. The length of material is supplied from the supplying roller 27 through the auxiliary guide roller 32a and is guided to the guide roller 21, and the length of material which has undergone a sputtering treatment is guided through the other auxiliary guide roller 32b and wound around the winding roller 28. A guard plate 33 stands in a position corresponding to a gap formed between both auxiliary guide rollers 32a and 32b, and the water cooling piping 25 is disposed, in the same manner as those of the pillars 24, on one side of the guard plate 33 which does not face the target 15.

A pipe 34 connected to a pump for evacuating the interior of the sputtering apparatus body 1 is connected to the base support 2. The pipe 34 branches into: a line connected to a diffusion pump 36 through a final-evacuation valve 35; and a line connected to a mechanical booster pump 38 and a rotary pump 39 through a pre-evacuation valve 37, and the diffusion pump 36 and the mechanical booster pump 38 are connected with each other through an auxiliary valve 40. A leak valve 41 is connected to the pipe 34. A pipe 45 which is connected to an Ar gas bomb 43 and an oxygen gas bomb 44 through valves 42a and 42b is joined to the casing 3.

The operation of the apparatus thus constituted will now be described.

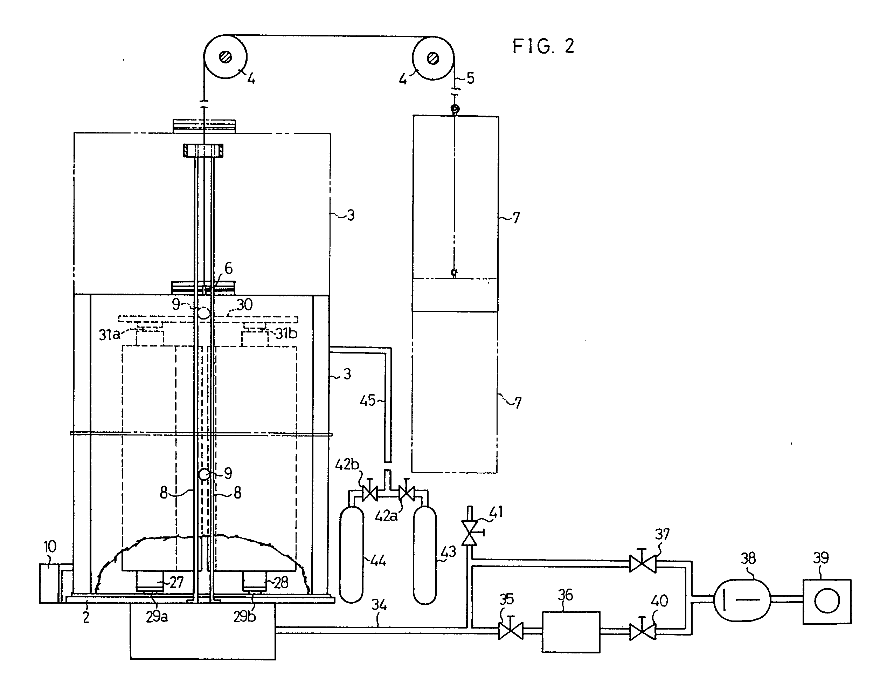

The motor 10 is rotated in the normal direction while the inner pressure of the casing 3 is maintained in equilibrium with the atmospheric pressure after the leak valve 41 has been released. The pushing-up member 13 is pushed up, so that the casing 3 is rifted and suspended, as shown by the chain line cn Fig. 2. In this state, the supplying roller 27 is detached from the driving shaft 29a and the driven shaft 31a, and the length of material 20 is wound around the supplying roller 27. then, the supplying roller 27 around which the length of material 10 has been wound is set between the driving shaft 29a and the driven shaft 31a. The length of material 10 is led by its one end over the auxiliary guide roller 32a, the guide rollers 21 and the auxiliary guide roller 32b to the winding roller 28, and it is attached at its end to the surfaces of the winding roller 28. Next, the motor 10 is driven to rotate in the reverse direction, and the pushing-up member 13 is moved down by the action of the pinion 11 and the rack 12, thus mounting the casing 3 on the base support 2. The casing 3 is mounted on the base support 3 while maintaining the air-tight property therebetween effected by its weight and the packing.

Next, the interior of the sputtering apparatus body 1 is evacuated. As the diffusion pump 36 and the rotary pump 39 are constantly working, the leak valve 41 is first closed and the pre-evacuation valve 31 is opened. After the internal pressure of the sputtering apparatus body 1 is reduced to equal or less than 20 Torr by the effect of the rotary pump 39, the mechanical booster pump 38 is actuated. Then, after the internal pressure of the apparatus body 1 is reduced equal to or less than $5 \times 10^{-2}$ Torr, the pre-evacuation valve 37 is closed, and the auxiliary valve 40 and the final-evacuation valve 35 are opened so as to evacuate the interior of the apparatus body 1 to the higher degree of vacuum of $1,333.10^{-3}$ Pa ($10^{-5}$ Torr).

If the exhaust speed is reduced by gas discharged from the length of material 20, it is possible to drive the winding roller 28 and the supplying roller 27 such as to wind up and rewind the length of material 20 in order to raise the exhaust speed. In this case, the winding up and rewinding operation is carried out after the final-evacuation valve 35 is opened. If the amount of discharged gas is large, it is to be done after the mechanical booster pump 38 is actuated. The winding up and rewinding operation is carried out at a speed of about 10 m/min.

Next, while being supplied with argon gas from an argon gas bomb 43, the interior of the apparatus body 1 is gradually evacuated by the diffusion pump 36, thus maintaining a low-pressure argon gas atmosphere therein.

Next, the water cooling piping 25 is supplied with a quantity of water, and the supplying roller 27 and the winding roller 28 are driven while a high direct current voltage is applied between the target 15 and the anode 19. A glow discharge is caused by applying a high direct current voltage between the target 15 and the anode 19, and a quantity of argon gas in the sputtering apparatus body 1 is ionized by the discharge energy. Argon ions caused by this ionization are accelerated toward the target (cathode) 15 and they collide against the target 15 such as to drive metal out of the surface of the target 15. The metal driven out from the surface of the target 15 radially scatters out of the target 15. The length of material 20 passes over the auxiliary guide roller 32a, the guide rollers 21 and the auxiliary guide roller 32b, that is, a generally circular transferring passage encircling the substantially entire circumference of the target 15, and it is wound around the winding roller 28. Accordingly, the area on the length of material 20 to which the sputtering metal radially scattering from the target 15 is attached is so wide that a metal·coat having prescribed thickness is securely formed on the surface of the length of material 20, even when the winding speed of the winding roller 28 is increased. According to the above-described related art, the winding speed is at most 2 to 3 m/min in order to form a coating having thickness of 500 angstrom, but this embodiment is capable of forming a metal coat having thickness of 500 angstrom on the surface of the length of metal 20 at a winding speed of 6 m/min, thus performing the sputtering treatment at a speed two or three times higher than that of the apparatus according to the related art.

Sputtering metal scattered out of the target 15 sticks to portions other than the surface of the length of material 20, but, in this embodiment, pillars 24 disposed on the inner side of the guide rollers 21 (on the side of the target 15) function as covers for the guide rollers 21, namely, as guard plates, and the guide rollers 21 are constantly cooled by the water cooling piping 25, so that the sputtering metal is prevented from sticking to and heating the guide rollers 21. It is thus possible to securely reduce contaminations of the length of material 20 due to the sputtering metal sticking to the guide rollers 21 or reduce the influence of the heat applied thereto upon the length of material 20.

When a metal oxide coat is formed on the length of material in place of the metal coat from the metal which constitutes the target 15, the valve 42b communicated to the oxygen gas bomb 44 is opened such as to supply oxygen gas together with argon gas to the interior of the sputtering apparatus body 1, a high direct current voltage is applied between the target 15 and the anode 19 while a low-pressure argon-oxygen mixture atmosphere is maintained in the apparatus body 1. When the argon and oxygen gas exists, metal which has been driven out of the target 15 in a manner similar to that described above is immediately oxidized by oxygen ions and changed into an oxide, it is attached in the form of the oxide to the length of material 20, thus forming a coat of the metal oxide on the surface of the length of material 20.

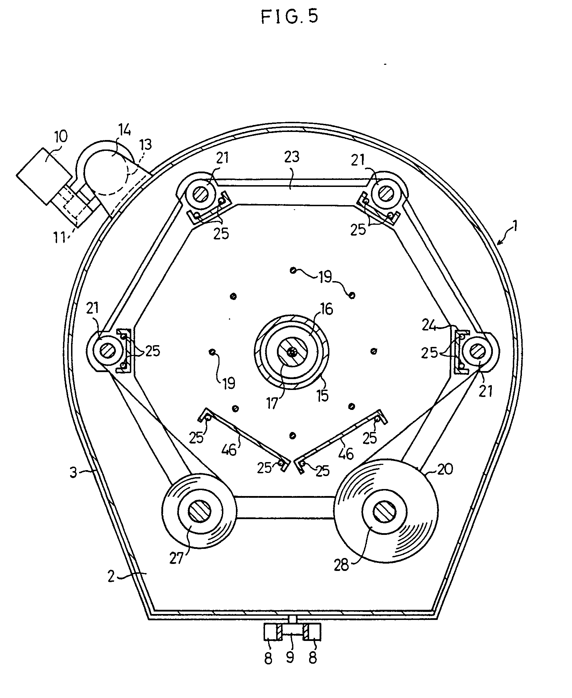

As shown in Fig. 5, the supplying roller 27 and the winding roller 28 may be disposed on the circumferential surface on which the guide rollers 21 are disposed. In such a case, it is necessary to provide a guard member 46 for preventing sputtering metal from sticking to the length of material 20 wound around the supplying roller 27 and the winding roller 28.

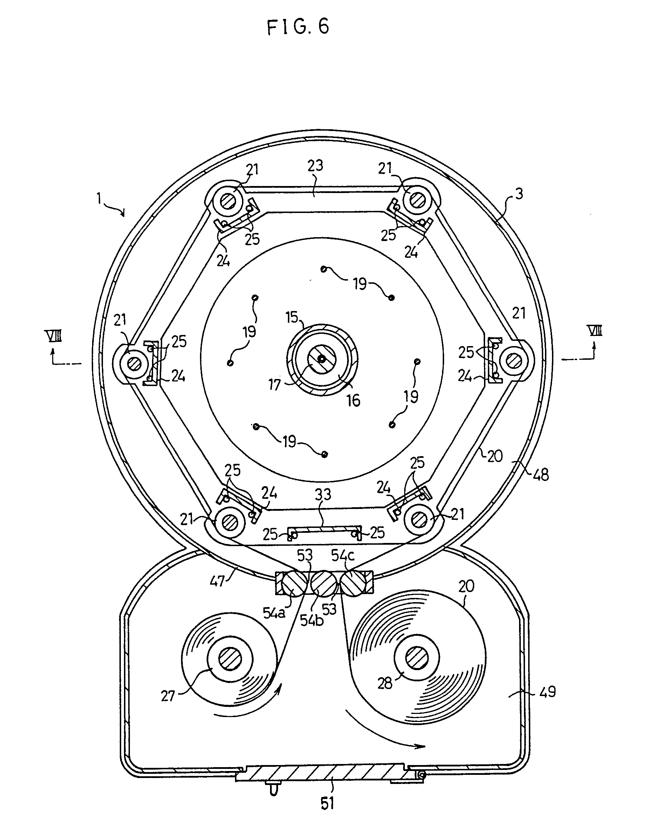

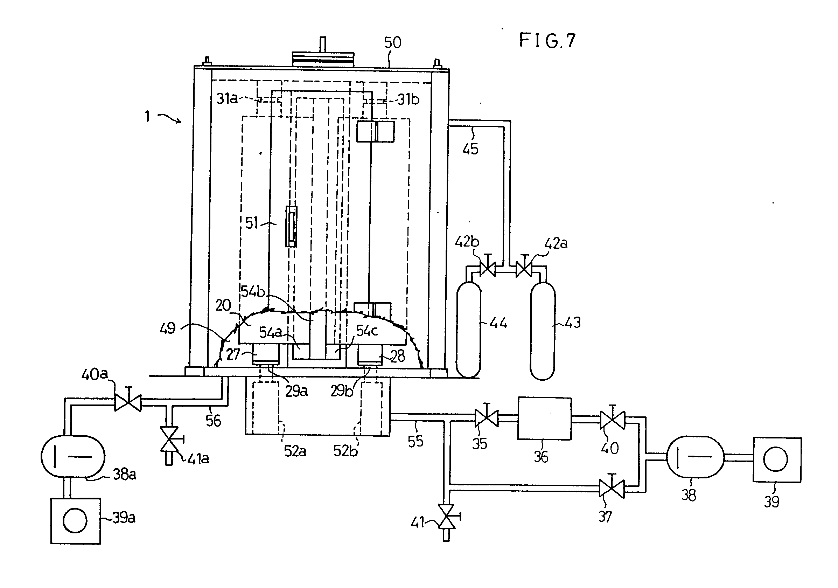

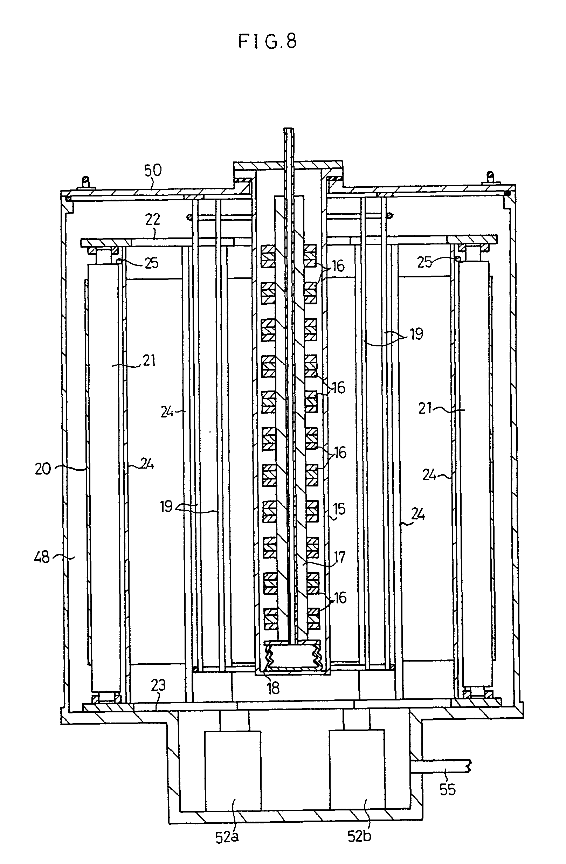

The second embodiment of the present invention will now be described with reference to Figs. 6 to 10.

The sputtering apparatus body 1 is partitioned such that the casing 3 is separated by a partition wall 47 to form a sputtering treatment chamber 48 and a work accommodating chamber 49. The sputtering treatment chamber 48 is closed and sealed at its top opening by a lid 50. An air-tight door is disposed on the front of the work accommodating chamber 49 (lower side of Fig. 6).

A target 15 in the form of a cylinder with a bottom is inserted from the outside of the lid 50 while maintaining air-tight property thereof and is detachably fixed to the center of the sputtering treatment chamber 48.

The supplying roller for supplying the length of material 20 and the winding roller 28 for winding up the length of material which has undergone a sputtering treatment are vertically disposed in the work accommodating chamber 49. Both rollers are disposed on a bottom wall and detachably attached between the driving shafts 29a and 29b driven by external driving mechanisms 52a and 52b, and the driven shafts 31a and 31b rotatably attached to the upper portion of the chamber.

The driving mechanisms 52a and 52b control the driving shafts 29a and 29b such that, when the length of material 20 supplied from the supplying roller 27 is wound around the winding roller 28, the peripheral speed of the winding roller 28 is higher than that of the supplying roller 27 by a constant degree. That is, looseness, wrinkles, etc. of the length of material 20 are prevented by providing a difference between peripheral speeds of these rollers 27 and 28 such as to apply a constant tension to the length of material in the winding direction thereof. Accordingly, the length of material 20 is guided between the guide rollers 21 while being tensioned at a constant degree by both the rollers 27 and 28. The tension is set to be at a degree such as to evade a deformation of the length of material 20. In this embodiment, it is preferably 2 to 20 kg/cm.

An openings for communicating the sputtering treatment chamber 48 and the work accommodating chamber 49 with each other is formed in the central portion of partition wall 47 which separates both chambers 48 and 49. The opening is closed by three auxiliary rollers 54a, 54b and 54c vertically disposed such as to form gaps 53 which allow the length of material 20 to pass therethrough. The length of material 20 passes between the auxiliary guide rollers 54a and 54b and introduced into the sputtering treatment chamber 48, and a part of the length of material which has undergone a sputtering treatment is wound up by the winding roller 28 after passing between the auxiliary guide rollers 54b and 54c. The guard plate 33 for preventing sputtering metal from sticking to the auxiliary guide rollers 54a, 54b and 54c is disposed in the sputtering treatment chamber 48, and the water cooling piping 25 is disposed on one side of the guard plate 33 which does not face the target 15 in the same manner as the pillars 24.

A pipe 55 connected to a pump for evacuating the interior of the sputtering treatment chamber 48 is joined to this chamber.

On the other hand, a pipe 56 connected to another pump independent of the exhaust system for the sputtering treatment chamber 48 is joined to the work accomodating chamber 49 in order to evacuate the interior thereof.

The operation of the apparatus thus arranged as the second embodiment of the present invention will now be described. The door 51 of the work accommodating chamber 49 is opened while the internal pressure of the sputtering treatment chamber 48 and the work accommodating chamber 49 is being in equilibrium with the atmospheric pressure after the leak valves 41 and 41a have been opened. The supplying roller 27 is detached from the driving shaft 29a and the driven shaft 31a, and the length of material 20 is wound around the supplying roller 27. Next, the supplying roller around which the length of material 20 is wound is set between the driving shaft 29a and the driven shaft 31a. The length of material 20 is led by its one end through the gap formed between the auxiliary guide roller 54a and 54b to the interior of the sputtering treatment chamber 48 and is set around the six guide rollers 21. It is then introduced again into the work accommodating chamber 49 through the gap between the guide rollers 54b and 54c, and the end of the length of material 20 is attached to the surface of the winding roller 28. Then, the lid 50 and the door 51 are closed in an air-tight manner.

Next, the interior of the sputtering apparatus body 1 is evacuated. At this time, it is not necessary to evacuate the work accomodating chamber 49 to a degree as high as the sputtering treatment chamber 48. The vacuum in the work accommodating chamber 49 may be maintained at $10^{-2}$ to $10^{-3}$ Torr.

Next, while the sputtering treatment is being performed, the length of material 20 passes between the auxiliary guide rollers 54a and 54b and the guide rollers 21 then between the auxiliary guide rollers 54b and 54c, finally being wound around the winding roller 28.

At this time, the winding roller 28 is controlled such that the peripheral speed of the winding roller 28 is higher than that of the supplying roller 27 by a constant degree. That is, the length of material 20 is guided on the guide rollers 21 while tensioned by a constant degree in the winding direction thereof. It is thereby prevented from loosening while being guided on the guide rollers 21. Even when it is loosed and wrinkled, it is stretched by the tension. Thus, it is possible to uniformly apply a sputtering treatment to the length of material 20 over the entire area thereof.

When a sheet of cloth is used as the length of material 20, even the interior of the mesh can be coated with metal oxide since the mesh of the cloth is opened by the above-described tensile force.

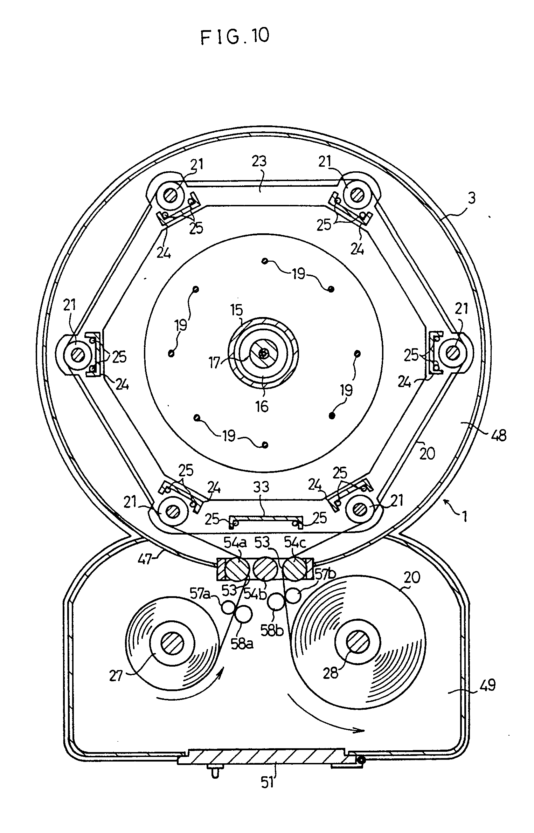

A means for preventing the length of material from loosening between the supplying roller 27 and the winding roller 28 may be constituted as follows. As shown in Fig. 10, driving capstans 57a, and 57b and pinch rollers 58a and 58b may be disposed on the sides of the supplying roller 27 and the winding roller 28 in order to set the winding speed to be consistently higher than the supplying speed by providing the driving force through the capstans 57a and 57b. In this case, the capstan 57a and the pinch roller 58a on the supplying side may be removed and the driving mechanism itself may be designed such as to tension the length of material in the reverse direction. That is, any method is applicable if only it can apply tensile force between both rollers 27 and 28, and it is not limited to the above constitution and combination.

A tensile force applying means for tensioning the length of material 20 in the direction perpendicular to the supplying direction may be provided. The length of material 20 can thereby be prevented from expanding considerably in one direction, and, when a material in the form of a mesh is used, it is possible for metal to attach to the interior of the mesh, because the mesh is uniformly expanded in both longitudinal and transverse directions.

As shown in Fig. 9, only a gap which allows the length of material to pass therethrough may be formed in the partition wall 47 located between the sputtering treatment chamber 48 and the work accommodating chamber 49, instead of disposing the auxiliary guide rollers 54a to 54c in the partition wall 47. In that case, a contacting surface facing the length of material 20 may preferably formed smoothly in order to reduce the friction thereof.

Instead of forming the upper and lower supporting frames 22 and 23, the upper wall of the sputtering treatment chamber 48 may be extended to the position in which the guide rollers 21 are disposed such as to rotatably support the guide rollers 21 between the upper and bottom walls, and a cover for the guide rollers 21 may be formed otherwise. This cover is not necessarily provided.

The present invention is not limited to the above-described embodiment, and it is possible to carry out the present invention as follows.

Guide pins 111 may be protrusively disposed at both ends of the outer peripheral surface of the guide roller 21, as shown in Fig. 11; a fastener 112 may be attached to the surface of the guide roller 21 as shown in Fig. 12; or the surface of the guide roller 21 may be formed to be a roughened surface. These arrangements enable the length of material to be tensioned at a lower level, thus being specifically advantageous when applying a sputtering treatment to materials such as cloth which can not be highly tensioned. When the guide rollers 21 are positively driven, it is possible to further reduce the tension which is applied to the length of material 20.

The number of the guide rollers 21 and the interval at which this rollers are disposed vary in accordance with the kind of cloth used as the length of material and with the intensity of the tension applied thereto. The interval may preferably be 20 to 80 cm, and, preferably, more than five guide rollers 21 may be disposed in order that the length of material 20 is moved around the target 15 while assuming a substantially circular form.

As shown in Figs 13 to 16, a pillar 24 having a function of a guard member may be provided in the form of an angle, an arc and a channel and a plate in section.

It is not always necessary to dispose the pillars 24 as guard members for guide rollers 21 on the inside thereof. The pillars 24 may be disposed on the outside of the transferring passage of the length of material 20, and guard members may be provided such as to be separate from the pillars 24. In that case, the material for the guard member is not limited to metal and may be ceramics, etc. having heat-resisting property. If a time for continously operating the sputtering apparatus is short, the water cooling piping 25 is not necessarily disposed while the guard members are disposed in spaced relationship with the guide rollers 21.

The apparatus may be arranged such that the guide rollers 21 may be positively driven.

The metal for forming the target 15 is not specifically defined, any metal including all metal (alloys) available for sputtering process may be applicable. That is, gold, silver, aluminium, tin, zinc, titanium, nickel, copper, cobalt, chromium, etc. as simple substance metal, and hastelloy, permalloy and stainless steel as alloys are suitable in terms of corrosion resistance and color. These kinds of metals or alloys may be selected in accordance with purpose, color and cost.

In these embodiments, a nitrogen gas bomb may be substituted for the oxygen gas bomb. It is thereby possible to form a metal nitride coat instead of metal oxide coat on the surface of the length of material 20. An inert gas such as xenon may be used instead of argon gas.

In the first embodiment, instead of forming the sputtering apparatus body 1 by the base support 2 and the casing 3 mounted on the upper surface of the support 2, the sputtering apparatus body 1 may be constituted by a casing having a bottom and a lid for covering the upper opening of the casing in a air-tight manner.

It is apparent that these embodiments can be largely altered or modified without departing from the spirit and scope of the present invention, and the present invention is not limited to those particular embodiments while it is specified in the appended claims.

## Claims

1. A sputtering apparatus for applying, in a casing (3), a sputtering treatment to a length of material (20) such as cloth or a film with sputtering metal which has flown off a target (15) arranged in said casing (3), while transferring said length of material (20) and guiding it by means of a least one guide roller (21), characterized in that said target (15) being a cylindrical target, a plurality of of guide rollers (21) being disposed on a circumferential surface concentric with said cylindrical tartet (15) such as to make a moving path of said length of material (20) conform to a circumferential surface encircling said cylindrical target (15), each of said guide rollers (21) supporting an overall width of said length of material (20) substantially by an overall length thereof; and a plurality of pillars (24) each disposed adjacent a respective one of said guide rollers (21) in obscuring relationship between such guide roller (21) and said cylindrical target (15), each said pillar (24) being wider than the diameter of the respective said guide roller (21) obscured thereby.

2. A sputtering apparatus according to claim 1, further comprising a supplying roller (27) for supplying said length of material (20), and a winding roller (28) for winding up said length of material (20) which has undergone a sputtering treatment.

3. A sputtering apparatus according to claim 2, wherein said supplying roller (27) and said winding roller (28) are disposed on the outside of said circumferential surface defined by said guide rollers (21).

4. A sputtering apparatus according to anyone of claims 1 to 3, wherein said cylindrical target (15) includes inside a vertically movable supporting cylinder (17) and a plurality of permanent magnets (16) attached to said supporting cylinder (17) at given intervals.

5. A sputtering apparatus according to claim 4, further comprising: a bellows (18) disposed under the lower end of the said supporting cylinder (17), said bellows (18) vertically expanding when supplied with compressed air from the outside; and an anode in the form of a cage having thin rods (19) extending vertically, said anode being located on a circumferential surface concentric with said cylindrical target (15).

6. A sputtering apparatus according to anyone of claims 1 to 5, wherein each of said pillars (24) has at least one water-cooling piping (25) for cooling said pillar, which is disposed on one side of each pillar (24) which does not face said target (15), and said pillar (24) is disposed in the vicinity of each of said guide rollers (21).

7. A sputtering apparatus according to anyone of claims 1 to 6, further comprising upper and lower supporting frames (22, 23) rotatably supporting said plurality of guide rollers (21) disposed at equal intervals.

8. A sputtering apparatus according to anyone of claims 1 to 7, further comprising; a pair of auxiliary guide rollers (32a, 32b) disposed between a pair of said guide rollers (21) located in the vicinity of said supplying roller (27) and said winding roller (28); and a guard plate (33) vertically disposed between said auxiliary guide rollers (32a, 32b) and said cylindrical target (15), said guard plate (33) has a water-cooling piping (25) disposed on one side of said guard plate (33) which does not face said target (15).

9. A sputtering apparatus according to claim 2, wherein said supplying roller (27) and said winding roller (28) are disposed on a circumferential surface defined by said guide rollers (21), and guard members (46) for preventing sputtering metal from sticking to said supplying roller (27) and said winding roller (28) are provided.

10. A sputtering apparatus according to anyone of claims 2 to 8, wherein the cylindrical target (15) and the plurality of guide rollers (21) being arranged within a sputtering treatment chamber (48); and the supplying roller (27) and the winding roller (28) being arranged within a work accommodating chamber (49) being adjacent to said sputtering treatment chamber (48).

11. A sputtering apparatus according to claim 10, further comprising: a partition wall (47) for separating said sputtering treatment chamber (48) and said work accommodating chamber (49), said partition wall (47) having two gaps (53) which allow said length of material (20) to pass therethrough; and exhaust systems for evacuating said sputtering treatment chamber (48) and said work accommodating chamber (49), said exhaust systems being independently adapted to each of said chambers (48, 49).

12. A sputtering apparatus according to claim 11, wherein said gaps (53) are formed between three auxiliary guide rollers (54a, 54b, 54c).

13. A sputtering apparatus according to anyone of claims 10 to 12, wherein at least one of said supplying roller (27) and said winding roller (28) has a tensioning means (52a, 52b, 57a, 57b, 58a, 58b) for applying a constant tensile force to said length of material (20).

14. A sputtering apparatus according to claim 13, wherein said tensioning means includes an external driving mechanism (52a, 52b) which rotates said winding roller (28) at a constant peripheral speed higher than that of said supplying roller (27) by a given degree.

15. A sputtering apparatus according to claim 13, wherein said tensioning means includes driving capstans (57a, 57b) and pinch roller (58a, 58b) attached to said supply roller (27) and said winding roller (28).

**Patentansprüche**

1. Zerstäubungsgerät zum Durchführen einer Sputteringbehandlung an einem Materialabschnitt (20), wie Stoff oder einem Film, in einem Gehäuse (3) mit durch Ionenbeschuß zerstäubtem Metall, welches von einem in dem Gehäuse (3) angeordneten Target (15) weggeflogen ist, während der Materialabschnitt (20) übertragen und mittels mindestens einer Führungsrolle (21) geführt wird,

dadurch gekennzeichnet, daß das Target (15) ein zylindrisches Target ist, daß eine Vielzahl von Führungsrollen (21) auf einer Umfangsfläche, welche mit dem zylindrischen Target (15) konzentrisch ist, angeordnet sind, um einen Bewegungsweg des Materialabschnitts (20) mit einer Umfangsfläche, welche das zylindrische Target (15) umgibt, in Übereinstimmung zu bringen, wobei jede der Führungsrollen (21) die gesamte Breite des Materialabschnitts (20) im wesentlichen über die gesamte Länge stützt, und

daß eine Vielzahl von Pfeilern (24) vorgesehen ist, von welchen jeder neben einer der Führungsrollen (21) so zwischen einer Führungsrolle (21) und dem zylindrischen Target (15) angeordnet ist, daß er die Führungsrolle verbirgt, wobei jeder der Pfeiler (24) breiter ist als der Durchmesser der entsprechenden Führungsrolle (21), welche von ihm verborgen wird.

2. Zerstäubungsgerät nach Anspruch 1, welches ferner eine Zuführrolle (27) zum Zuführen des Materialabschnitts (20) und eine Wickelrolle (28) zum Aufwickeln des Materialabschnitts (20), welcher einer Zerstäubungsbehandlung unterzogen worden ist, enthält.

3. Zerstäubungsgerät nach Anspruch 2, bei welchem die Zuführrolle (27) und die Wickelrolle (28) außerhalb der Umfangsfläche, welche durch die Führungsrollen (21) begrenzt wird, angeordnet sind.

4. Zerstäubungsgerät nach einem der Ansprüche 1 bis 3, bei welchem das zylindrische Target (15) im Innnern einen vertikal bewegbaren Stützzylinder (17) und eine Vielzahl von Dauermagneten (16) enthält, welche an dem Stützzylinder (17) in gegebenen Abständen befestigt sind.

5. Zerstäubungsgerät nach Anspruch 4, welches ferner einen Blasebalg (18), welcher unter dem unteren Ende des Stützzylinders (17) angeordnet ist und vertikal expandiert, wenn ihm von außen Druckluft zugeführt wird, und eine Anode in Form eines Käfigs enthält, welcher dünne, sich vertikal erstreckende Stäbe (19) hat, wobei die Anode auf einer Umfangsfläche angeordnet ist, welche mit dem zylindrischen Target (15) konzentrisch ist.

6. Zerstäubungsgerät nach einem der Ansprüche 1 bis 5, bei welchem jeder der Pfeiler (24) mindestens eine wasserkühlende Rohrleitung (25) zum Kühlen des Pfeilers hat, welche auf einer Seite jedes Pfeilers (24) angeordnet ist, welche nicht dem Target (15) gegenüberliegt, und bei welchem der Pfeiler (24) jeweils in der Nähe jeder Führungsrolle (21) angeordnet ist.

7. Zerstäubungsgerät nach einem der Ansprüche 1 bis 6, welches ferner obere und untere Stützrahmen (22, 23) enthält, welche die Vielzahl der Führungsrollen (21), welche in gleichen Abständen angeordnet sind, drehbar tragen.

8. Zerstäubungsgerät nach einem der Ansprüche 1 bis 7, welches ferner ein Paar von Hilfsführungsrollen (32a, 32b), welche zwischen einem Paar der Führungsrollen (21), welche in der Nähe der Zuführrolle (27) und der Wickelrolle (28) liegen, angeordnet sind, und eine Schutzplatte (33) enthält, welche vertikal zwischen den Hilfsführungsrollen (32a, 32b) und dem zylindrischen Target (15) angeordnet ist, wobei die Schutzplatte (33) eine wasserkühlende Rohrleitung (25) hat, welche auf einer Seite der Schutzplatte (33) angeordnet ist, welche nicht dem Target (15) gegenüberliegt.

9. Zerstäubungsgerät nach Anspruch 2, bei welchem die Zuführrolle (27) und die Wickelrolle (28) auf einer Umfangsfläche angeordnet sind, welche von den Führungsrollen (21) abgegrenzt wird, und Schutzelemente (46) vorgesehen sind, welche verhindern, daß zerstäubungsmetall an der Zuführrolle (27) und der Wickelrolle (28) haften bleibt.

10. Zerstäubungsgerät nach einem der Ansprüche 2 bis 8, bei welchem das zylindrische Target (15) und die Vielzahl der Führungsrollen (21) innerhalb der Zerstäubungsbehandlungs-Kammer (48) angeordnet sind und die Zuführrolle (27) und die Wickelrolle (28) innerhalb einer Werkstück-Aufnahmekammer (49), welche an die Zerstäubungsbehandlungs-Kammer (48) angrenzt.

11. Zerstäubungsgerät nach Anspruch 10, welches ferner eine Trennwand (47) zum Trennen der Zerstäubungsbehandlungs-Kammer (48) und der Werkstück-Aufnahmekammer (49) enthält, wobei die Trennwand (47) zwei Lücken (53) hat, welche dem Materialabschnitt (20) einen Durchgang ermöglichen, und Abzugssysteme zum Evakuieren der Zerstäubungsbehandlungskammer (48) und der Werkstück-Aufnahmekammer (49), wobei die Abzugssysteme unabhängig an jede der Kammern (48, 49) angepaßt, sind.

12. Zerstäubungsgerät nach Anspruch 11, bei welchem die Lücken (53) zwischen drei Hilfsführungsrollen (54a, 54b, 54c) gebildet sind.

13. Zerstäubungsgerät nach einem der Ansprüche 10 bis 12, bei welchem mindestens eine der Zuführrolle (27) und der Wickelrolle (28) Spannmittel (52a, 52b, 57a, 57b, 58a, 58b) zum Anlegen einer konstanten Zugkraft an den Materialabschnitt (20) hat.

14. Zerstäubungsgerät nach Anspruch 13, bei welchem die Spannmittel einen externen Antriebsmechanismus (52a, 52b) enthalten, welcher die Wickelrolle (28) mit einer konstanten Umfangsgeschwindigkeit rotieren läßt, welche um einen bestimmten Grad höher ist als die der Zuführrolle (27).

15. Zerstäubungsgerät nach Anspruch 13, bei welchem die Spannmittel Treibrollen (57a, 57b) und Klemmrollen (58a, 58b) enthalten, welche an der Zuführrolle (27) und der Wickelrolle (28) befestigt sind.

**Revendications**

1. Appareil de pulvérisation pour soumettre à un traitement par pulvérisation, dans un carter (3), une longueur de matériau (20) tel qu'une étoffe ou un film, à l'aide d'un métal de pulvérisation qui été expulsé d'un collecteur (15) installé dans ledit carter (3), tout en transférant ladite longueur de matériau (20) et en la guidant au moyen d'au moins un rouleau de guidage (21),
caractérisé par le fait que ledit collecteur (15) et un collecteur cylindrique, de multiples rouleaux de guidage (21) étant agencés sur une surface circonférentielle, concentriquement audit collecteur cylindrique (15), de manière à établir un trajet de mouvement de ladite longueur de matériau (20) conformément à une surface circonférentielle entourant ledit collecteur cylindrique (15), chacun desdits rouleaux de guidage (21) supportant, pour l'essentiel par toute sa longueur, une pleine largeur de ladite longueur de matériau (20); et de multiples montants (24) étant disposés chacun au voisinage direct de l'un respectif desdits rouleaux de guidage (21), en relation de recouvrement entre ledit rouleau de guidage (21) et ledit collecteur cylindrique (15), chaque montant précité (24) étant plus large que le diamètre dudit rouleau de guidage respectif (21) qu'il recouvre.

2. Appareil de pulvérisation selon la revendication 1, présentant en outre un rouleau d'alimentation (27) pour délivrer ladite longueur de matériau (20), et un rouleau d'enroulement (28) pour enrouler ladite longueur de matériau (20) qui a été soumise à un traitement par pulvérisation.

3. Appareil de pulvérisation selon la revendication 2, dans lequel ledit rouleau d'alimentation (27) et ledit rouleau d'enroulement (28) sont disposés à l'extérieur de ladit surface circonférentielle délimitée par lesdits rouleaux de guidage (21).

4. Appareil de pulvérisation selon l'une quelconque des revendications 1 à 3, dans lequel ledit collecteur cylindrique (15) présente, intérieurement, un cylindre de support (17) mobile verticalement, ainsi que de multiples aimants permanents (16) fixés audit cylindre de support (17) à des intervalles donnés.

5. Appareil de pulvérisation selon la revendication 4, comprenant en outre: un soufflet (18) situé au-dessous de l'extrémité inférieure dudit cylindre de support (17), ledit soufflet (18) étant soumis à expansion verticale lorsqu'il est alimenté par de l'air comprimé provenant de l'extérieur; et une anode revêtant la forme d'une cage présentant de minces tiges (19) s'étendant verticalement, ladite anode étant placée sur une surface circonférentielle, concentriquement audit collecteur cylindrique (15).

6. Appareil de pulvérisation selon l'une quelconque des revendications 1 à 5, dans lequel chacun desdits montants (24) comporte au moins une canalisation (25) de refroidissement par eau, pour refroidir ledit montant, disposée sur l'un des côtés de chaque montant (24) qui est tourné à l'opposé dudit collecteur (15), et ledit montant (24) se trouve au voisinage direct de chacun desdits rouleaux de guidage (21).

7. Appareil de pulvérisation selon l'une quelconque des revendications 1 à 6, présentant par ailleurs des châssis de support supérieur et inférieur (22, 23), qui supportent à rotation lesdits multiples rouleaux de guidage (21) disposés à des intervalles égaux.

8. Appareil de pulvérisation selon l'une quelconque des revendications 1 à 7, comprenant en outre: deux rouleaux auxiliaires de guidage (32a, 32b), interposés entre une paire desdits rouleaux de guidage (21) situés au voisinage direct dudit rouleaux d'alimentation (27) et dudit rouleau d'enroulement (28); et une plaque protectrice (33) intercalée verticalement entre lesdits rouleaux auxiliaires de guidage (32a, 32b) et ledit collecteur cylindrique (15), ladite plaque protectrice (33) étant pourvue d'une canalisation (25) de refroidissement par eau, disposée sur l'un des côtés de ladite plaque protectrice (33) qui est tourné à l'opposé dudit collecteur (15).

9. Appareil de pulvérisation selon la revendication 2, dans lequel ledit rouleau alimentation (27) et ledit rouleau d'enroulement (28) sont disposés sur une surface circonférentielle délimitée par lesdits rouleaux de guidage (21); et des organes de protection (46) sont prévus pour empêcher que du métal de pulvérisation adhère audit rouleau d'alimentation (27) et audit rouleau d'enroulement (28).

10. Appareil de pulvérisation selon l'une quelconque des revendications 2 à 8, dans lequel le collecteur cylindrique (15) et les multiples rouleaux de guidage (21) sont logés à l'intérieur d'une chambre (48) de traitement par pulvérisation; et le rouleau d'alimentation (27) et le rouleau d'enroulement (28) sont agencés à l'intérieur d'une chambre (49) d'adaptation du travail, adjacente à ladite chambre (48) de traitement par pulvérisation.

11. Appareil de pulvérisation selon la revendication 10, comprenant en outre: une paroi de cloisonnement (47) pour séparer ladite chambre (48) de traitement par pulvérisation et ladite chamber (49) d'adaptation du travail, ladite paroi de cloisonnement (47) étant munie de deux interstices (53) qui autorisent le défilement de ladite longueur de matériau (20); et des systèmes d'évacuation pour engendrer une dépression dans ladite chambre (48) de traitement par pulvérisation et dans ladite chambre (49) d'adaptation du travail, lesdits systèmes d'évacuation étant adaptés indépendamment à chacune desdites chambres (48, 49).

12. Appareil de pulvérisation selon la revendication 11, dans lequel lesdits interstices (53) sont ménagés entre trois rouleaux auxiliaires de guidage (54a, 54b, 54c).

13. Appareil de pulvérisation selon l'une quelconque des revendication 10 à 12, dans lequel au moins l'un desdits rouleaux respectifs d'alimentation (27) et d'enroulement (28) est équipé d'un moyen tendeur (52a, 52b, 57a, 57b, 58a, 58b), pour appliquer une force de traction constante à ladite longueur de matériau (20).

14. Appareil de pulvérisation selon la revendication 13, dans lequel ledit moyen tendeur présente un mécanisme d'entraînement extérieur (52a, 52b), qui fait tourner ledit rouleau d'enroulement (28) à une vitesse périphérique constant supérieure, d'une degré donné, à celle dudit rouleau d'alimentation (27).

15. Appareil de pulvérisation selon la revendication 13, dans lequel ledit moyen tendeur comprend des cabestans d'entraînement (57a, 57b) et des rouleaux de pincement (58a, 58b) fixés audit rouleau d'alimentation (27) et audit rouleau d'enroulement (28).

FIG. 1

FIG. 2

FIG. 3

EP 0 205 917 B1

FIG. 4        FIG.11        FIG.12

FIG. 9

4

FIG.5

FIG. 6

FIG.7

FIG.8

FIG.10

FIG.13

FIG.14

FIG.15

FIG.16

FIG. 17